(19)

Europäisches Patentamt

European Patent Office

Office européen des brevets

(11) **EP 3 745 206 A1**

(12) **EUROPEAN PATENT APPLICATION**

(43) Date of publication:
**02.12.2020 Bulletin 2020/49**

(21) Application number: **20174894.4**

(22) Date of filing: **15.05.2020**

(51) Int Cl.:
*G03F 7/20* (2006.01)          *G03F 9/00* (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.05.2019 JP 2019103169**

(71) Applicant: **CANON KABUSHIKI KAISHA OHTA-KU Tokyo 146-8501 (JP)**

(72) Inventor: **KOIZUMI, Ryo Ohta-ku,, Tokyo 146-8501 (JP)**

(74) Representative: **TBK Bavariaring 4-6 80336 München (DE)**

(54) **EXPOSURE APPARATUS AND ARTICLE MANUFACTURING METHOD**

(57)    An exposure apparatus that exposes a substrate is provided. The apparatus comprises a projection optical system (4) configured to project a pattern of a mask (2) onto the substrate, an adjusting unit (7a) configured to adjust an imaging characteristic of the projection optical system, and a control unit (10) configured to predict, using a prediction formula, a fluctuation of the imaging characteristic caused by the projection optical system absorbing exposure energy, control the adjusting unit based on a result of the prediction, and expose the substrate. The controller applies a mode in which, in a job for sequentially exposing a plurality of substrates, the imaging characteristic is measured before exposing each substrate, and after the job is completed, a prediction coefficient in the prediction formula is updated based on respective measurement results. In the mode, the imaging characteristic is measured not only inside an exposure angle of view set in the job but also outside the exposure angle of view set in the job.

# FIG. 2

**Description**

BACKGROUND OF THE INVENTION

Field of the Invention

The present invention relates to an exposure apparatus and an article manufacturing method.

Description of the Related Art

In an exposure apparatus, a projection optical system absorbs exposure energy during exposure, and this can lead to a fluctuation of the imaging characteristic. Such a fluctuation of the imaging characteristic due to exposure is called an exposure aberration. In the exposure apparatus, it is important to highly accurately correct such a fluctuation of the imaging characteristic. A fluctuation of the imaging characteristic during exposure depends on an exposure angle of view. Japanese Patent No. 6381188 discloses that a fluctuation of the imaging characteristic is predicted using a function depending on an exposure angle of view. Japanese Patent Publication No. 7-12012 discloses a technique in which the fluctuation of the imaging characteristic when an exposure process is interrupted due to a trouble or the like is obtained by actually measuring it, and the prediction information of the imaging characteristic at the time of restoration is corrected.

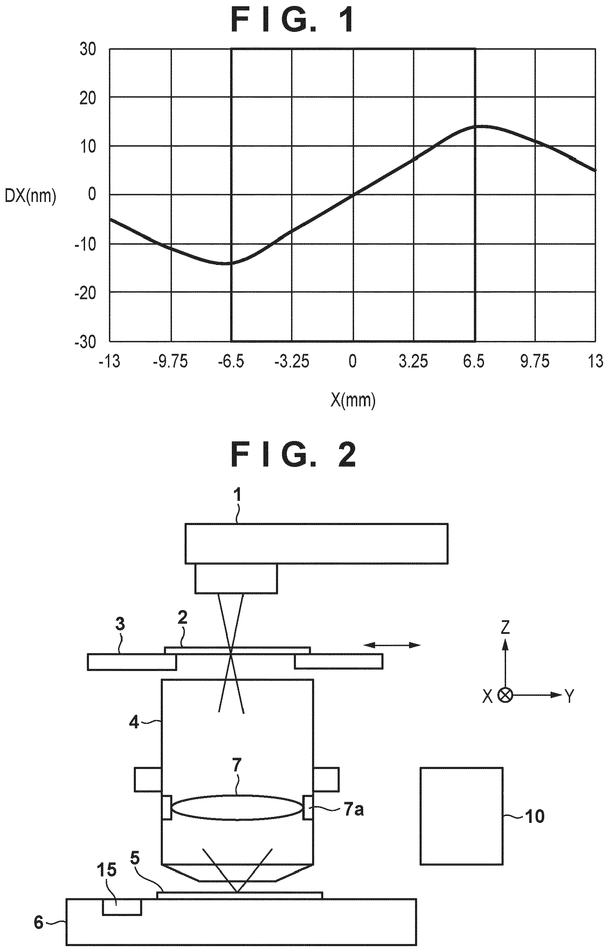

When the exposure angle of view is smaller than the maximum exposure angle of view, the influence of heat is different between inside and outside the exposure angle of view, so that a high-order component of the image height of the imaging characteristic fluctuates. Fig. 1 shows an example of an image deviation amount DX in the X direction as the imaging characteristic due to exposure heat when the exposure angle of view is smaller than the maximum exposure angle of view in the X direction. A frame indicated by solid lines indicates the range of the exposure angle of view. In general, when the exposure angle of view is small, a high-order component of the image height of the imaging characteristic fluctuates due to the influence of exposure heat.

Here, as in Japanese Patent Publication No. 7-12012, consider a case in which in order to accurately predict the fluctuation of the imaging characteristic during exposure, the imaging characteristic is measured a plurality of times at time intervals during the exposure. In this case, if the imaging characteristic is measured only at the image height inside the exposure angle of view, the high-order component of the image height cannot be measured correctly, so that an incorrect prediction coefficient is calculated. Further, if exposure is performed while performing correction using the incorrect prediction coefficient and then exposure of a job having a larger exposure angle of view is subsequently performed, a correction residual appears inside the exposure angle of view, resulting in creating a defective device in the job having the larger exposure angle of view.

SUMMARY OF THE INVENTION

The present invention has as its object to provide, for example, an exposure apparatus advantageous in highly accurate prediction of a fluctuation of the imaging characteristic of a projection optical system.

The present invention in its first aspect provides an exposure apparatus as specified in claims 1 to 8.

The present invention in its second aspect provides an article manufacturing method as specified in claim 9.

Further features of the present invention will become apparent from the following description of exemplary embodiments (with reference to the attached drawings).

BRIEF DESCRIPTION OF THE DRAWINGS

Fig. 1 is a graph showing an example of an imaging characteristic;
Fig. 2 is a view showing the arrangement of an exposure apparatus according to an embodiment;
Fig. 3 is a graph showing an image height fitting result obtained when the imaging characteristic (image deviation) is measured only inside an exposure angle of view;
Fig. 4 is a graph showing the imaging characteristic obtained when incorrect correction is performed;
Fig. 5 is a graph showing the imaging characteristic obtained when calibration for a job B is performed after a job A is completed;
Fig. 6 is a flowchart illustrating a control method of an exposure process according to the embodiment;
Fig. 7 is a graph showing an image height fitting result obtained when the imaging characteristic is measured also outside the exposure angle of view;

Fig. 8 is a graph showing an image height fitting result obtained when the imaging characteristic (focus deviation) is measured only inside the exposure angle of view;

Fig. 9 is a view showing an example of measurement marks arranged on a mask;

Figs. 10A and 10B are views each showing an example of timings of exposure on each wafer and imaging characteristic measurement; and

Fig. 11 is a view showing an example of measurement marks arranged on a mask stage.

DESCRIPTION OF THE EMBODIMENTS

Hereinafter, embodiments will be described in detail with reference to the attached drawings. Note, the following embodiments are not intended to limit the scope of the claimed invention. Multiple features are described in the embodiments, but limitation is not made an invention that requires all such features, and multiple such features may be combined as appropriate. Furthermore, in the attached drawings, the same reference numerals are given to the same or similar configurations, and redundant description thereof is omitted.

<First Embodiment>

Fig. 2 is a view showing the arrangement of an exposure apparatus according to an embodiment. The exposure apparatus may be a scanning exposure apparatus, or may be a step-and-repeat exposure apparatus. In the following example, the exposure apparatus is assumed to be a scanning exposure apparatus. Light emitted from an illumination system 1 is transmitted through a mask 2 having a pattern drawn thereon, and enters a projection optical system 4. The mask 2 is held by a mask stage 3. The mask 2 and a substrate 5 (wafer) are in a conjugate positional relationship, and the pattern on the mask 2 is transferred to the substrate 5 via the projection optical system 4. The substrate 5 is held by a substrate stage 6.

The projection optical system 4 can include an optical element 7 and a driving unit 7a that drives the optical element 7. The driving unit 7a functions as an adjusting unit that adjusts the imaging characteristic of the projection optical system 4 by driving the optical element 7. Note that the adjusting unit can adjust the imaging characteristic by performing at least one of driving of the optical element 7 of the projection optical system 4, driving of the mask stage 3, and driving of the substrate stage 6. In addition, Fig. 2 shows only one optical element 7 in the projection optical system 4, but the projection optical system 4 may include a plurality of optical elements, and the driving unit 7a may be configured to drive at least one of the plurality of optical elements.

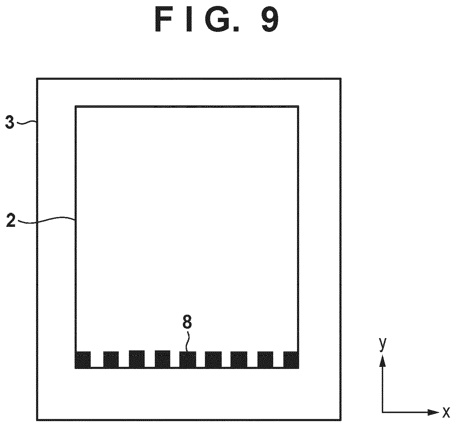

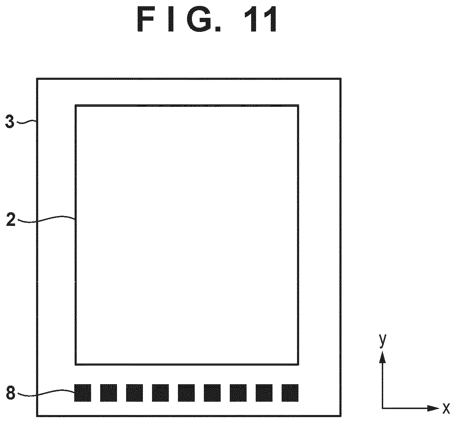

As shown in Fig. 11, the mask stage 3 includes a plurality of measurement marks 8 arranged over a length corresponding to the maximum exposure angle of view. The substrate stage 6 is provided with a measurement device 15 that detects light transmitted through the plurality of measurement marks 8 and the projection optical system 4. A control unit 10 can measure the imaging characteristic of the projection optical system 4 up to the maximum exposure angle of view using the measurement device 15. Note that the plurality of measurement marks 8 may not be provided on the mask stage 3 but may be formed on the mask 2 as shown in Fig. 9.

The control unit 10 comprehensively controls the respective units of the exposure apparatus to perform an exposure process. The control unit 10 can be formed by a computer apparatus including a CPU and a memory. Particularly, in this embodiment, the control unit 10 predicts, using a prediction formula, a fluctuation of the imaging characteristic caused by the projection optical system 4 absorbing exposure energy, controls the adjusting unit (driving unit 7a) based on the result of the prediction, and exposes the substrate.

The exposure process is managed by a "job". The job instructs to sequentially perform exposure on a plurality of substrates (in general, for example, 25 substrates per lot), and defines the exposure order and the like. Particularly, the job in this embodiment includes a shot layout parameter, and the exposure angle of view is determined by the shot layout.

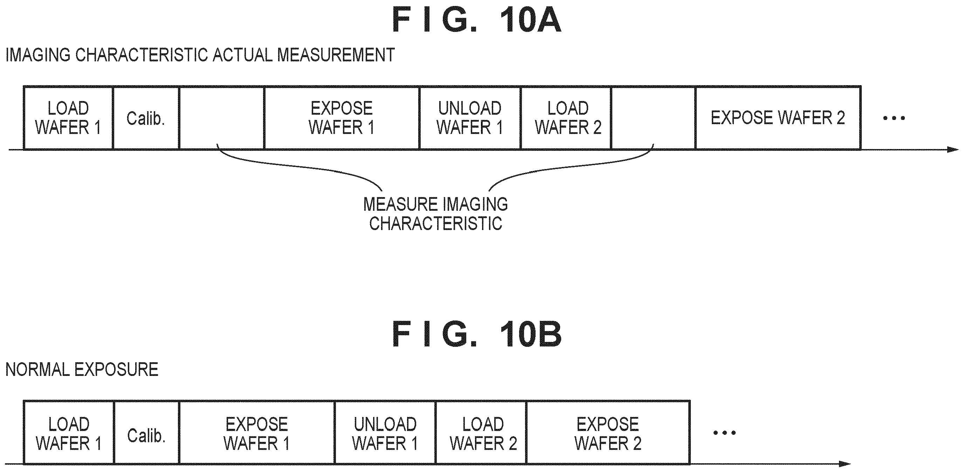

Fig. 10B shows the sequence in a normal exposure mode performed when a job is input. When a wafer is loaded, calibration (Calib.) of the exposure apparatus is first performed. The calibration includes obtaining offset values of hardware units by measurement to maintain the various types of accuracies of the exposure apparatus. After the calibration is completed, the wafer is exposed and unloaded. Subsequentially, loading, exposure, and unloading of a new wafer are repeated. This is the sequence in the normal exposure mode.

The optical element 7 arranged in the projection optical system 4 absorbs a part of exposure energy, and heat generated thereby can cause a change in refractive index or the like. This leads to a fluctuation of the imaging characteristic of the projection optical system 4. The imaging characteristic can include at least one of the focus, the magnification, the curvature of field, the distortion, the astigmatism, the spherical aberration, and the coma aberration. The control unit 10 predicts the fluctuation by applying a predetermined fluctuation model formula (prediction formula) using parameters such as the NA (Numerical Aperture) of the projection optical system 4, the NA of the illumination optical system 1, the exposure amount, the exposure time, the transmittance of the mask 2, and the like. However, it is known that the fluctuation of the imaging characteristic changes when the pattern on the mask to be used in actual exposure or the reflectance of a resist applied on the wafer changes. Therefore, if a condition at the time of actual exposure is different from a condition at the time of prediction, the fluctuation tendency of the imaging characteristic changes, and the fluctuation of the imaging characteristic may not be correctly predicted. In order to compensate for the difference, a method is employed in which the fluctuation of the imaging characteristic is actually measured during exposure performed under the actual exposure condition.

On the other hand, when the exposure angle of view is smaller than the maximum exposure angle of view, if actual measurement of the imaging characteristic is limited to the image height inside the exposure angle of view, an incorrect predicted value of the imaging characteristic is calculated. Thus, a method will be described below in which a correct predicted value of the imaging characteristic can be predicted even when the exposure angle of view is smaller than the maximum exposure angle of view.

As has been described above, the exposure apparatus in this embodiment is assumed to be a scanning exposure apparatus. Then, light emitted from the illumination system 1 is shaped by a rectangular exposure slit long in the X direction, and illuminates the mask 2. Here, the maximum exposure angle of view of the projection optical system 4 is assumed to be an exposure angle of view corresponding to an exposure range of 26 mm in the X direction. It is also assumed that the exposure angle of view of a job A is an exposure angle of view corresponding to an exposure range of 13 mm in the X direction, which is smaller than the maximum exposure angle of view, and the exposure angle of view of a job B is an exposure angle of view corresponding to the exposure range of 26 mm in the X direction, which is equivalent to the maximum exposure angle of view. For the job A, in order to compensate for the difference between the predicted value and actual fluctuation of the imaging characteristic, the imaging characteristic is actually measured during exposure. That is, the control unit 10 has an imaging characteristic actual measurement mode in which, in a job for sequentially exposing a plurality of substrates, the imaging characteristic is measured before exposing each substrate, and after the job is completed, a prediction coefficient in the prediction formula is updated based on the respective measurement results. The sequence of exposure and actual measurement in the imaging characteristic actual measurement mode is shown in Fig. 10A.

It is assumed that the job A is a job for sequentially exposing 25 wafers, and in the imaging characteristic actual measurement mode, a timing of actually measuring the imaging characteristic is immediately before exposing each wafer as shown in Fig. 10A. It is also assumed that in the imaging characteristic measurement, the imaging characteristic is measured at each of five image heights inside the exposure angle of view, and more specifically, the image heights with X = 0 mm, ±3.5 mm, and ±6.5 mm. In the imaging characteristic measurement, the control unit 10 moves the mask stage 3 in the Y direction such that the measurement marks 8 (Fig. 11) arranged on the mask stage 3 in advance enter the irradiation region, and measures the image deviation (positional deviation) by a sensor (not shown) arranged in the substrate stage 6.

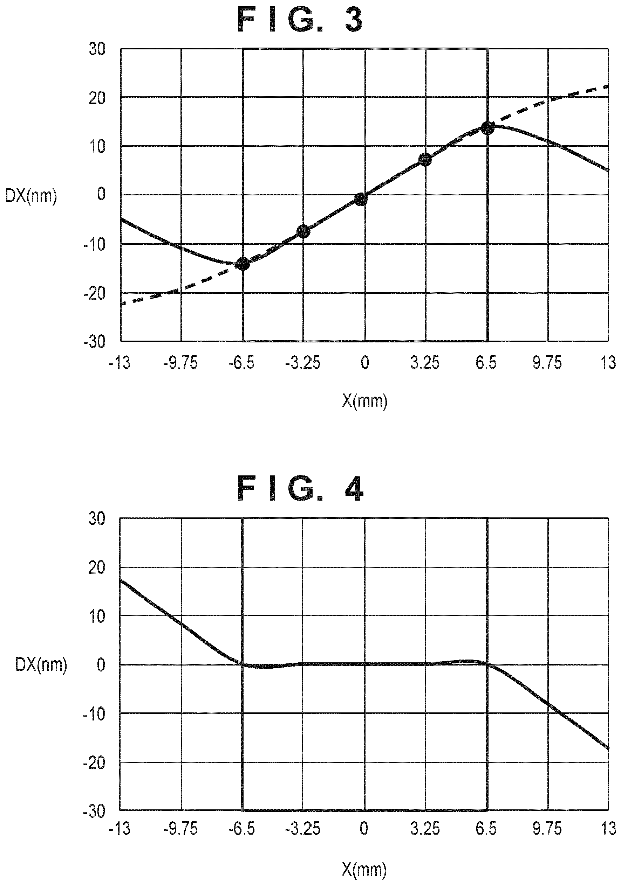

Fig. 3 shows an example of the result of the imaging characteristic measurement performed immediately before exposing the fifth wafer. The image deviation (DX) in the X direction is shown as an example of the imaging characteristic. Fig. 3 shows that the imaging characteristic has changed due to the influence of exposure heat in the exposure operations for first to fourth wafers. In Fig. 3, a solid line indicates the image height distribution of the imaging characteristic, and each filled circle indicates the measured value at each image height described above. The result of performing X image height fitting on these measured values is as follows:

the first-order component (magnification) of the X image height: 2.30

nm/mm ...(1)

the third-order component (distortion) of the X image height: -0.0035

nm/mm$^3$...(2)

The control unit 10 applies each order component to data obtained at each measurement timing. The control unit 10 fits, for each component, a predetermined fluctuation model (prediction formula) to the time-series data of the imaging characteristic obtained as the results of respective measurements, thereby obtaining a prediction coefficient.

A maximum fluctuation amount F1 of the imaging characteristic is calculated by the product of a fluctuation amount K of the imaging characteristic per unit light amount (unit exposure energy) and actual exposure energy Q obtained using exposure conditions (exposure time, exposure amount, scanning speed, exposure region information, and the like). That is, the maximum fluctuation amount F1 of the imaging characteristic is expressed by:

$$F1 = K \times Q \qquad\qquad ...(3)$$

Next, assuming that the imaging characteristic amount at a given time is $\Delta F1_k$, an imaging characteristic amount $\Delta F1_{k+1}$ obtained after exposure is performed for a time $\Delta t$ is expressed by an approximation formula below using F1 and a time constant TS1:

$$\Delta F1_{k+1} = \Delta F1_k + F1 \times (1 - \exp(-\Delta t/TS1)) \qquad\qquad ...(4)$$

Further, the imaging characteristic amount $\Delta F1_{k+1}$ obtained when exposure is not performed for the time $\Delta t$ is expressed by an approximation formula below:

$$\Delta F1_{k+1} = \Delta F1_k \times \exp(-\Delta t/TS1) \qquad\qquad ...(5)$$

Depending on whether exposure is performed or not, one of equations (4) and (5) is used. Based on the imaging characteristic obtained immediately before exposing each wafer and the measurement time, the fluctuation amount K of the imaging characteristic per unit light amount is obtained by performing fitting using equations (3) to (5). Since the imaging characteristic in this embodiment includes the magnification and the distortion, two types of fluctuation amounts K, that is, K for the magnification and K for the distortion are obtained. These amounts K are used as the prediction coefficients for the fluctuation of the imaging characteristic.

However, the correct image height characteristic is obtained by performing fitting on the solid line in Fig. 3 in a range of X = -13 mm to +13 mm. The result of performing order fitting of the X image height on the measured values in this range is as follows:

the first-order component (magnification) of the X image height: 2.47

nm/mm ...(6)

the third-order component (distortion) of the X image height: -0.0125

$nm/mm^3$ ...(7)

As has been described above, when the image height characteristic is obtained using the measured values in the range of image height with X = 0 mm, $\pm$3.5 mm, and $\pm$6.5 mm, fitting is performed by a fluctuation model using incorrect order components, resulting in obtaining the incorrect prediction coefficient K.

Fig. 4 shows the imaging characteristic at a given timing in a case in which exposure of the job A is performed again using the above-described incorrect prediction coefficient K. In accordance with the prediction coefficient K, the temporal fluctuation of the imaging characteristic is predicted, and exposure is performed while driving a correction system, a wavelength, or the like in the projection system such that the predicted amount is corrected.

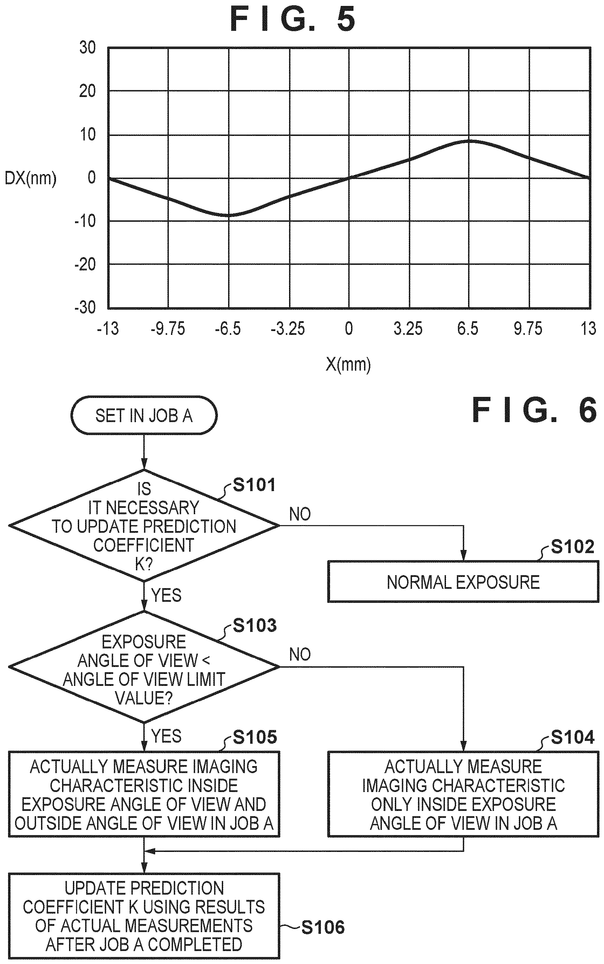

According to the characteristic shown in Fig. 4, excellent correction is performed inside the exposure angle of view in a range of X = -6.5 mm to +6.5 mm, but in the outside of the exposure angle of view, incorrect correction is performed so that large image deviation (DX) in the X direction occurs. Nevertheless, since exposure of the job A is performed in the range of X = -6.5 mm to +6.5 mm, no device defect occurs in the job A. However, if the job B is subsequentially input after the job A is completed, since the exposure angle of view of the job B is an exposure angle of view corresponding to an exposure range of X = -13 mm to +13 mm, the imaging characteristic is influenced by the incorrect correction. Further, consider a case in which in order to suppress such an influence, calibration is performed from the measured values at the both ends (X = $\pm$13 mm) of the exposure angle of view before exposing the first wafer of the job B. In the calibration, correction of the image deviation (DX) in the X direction is performed. An example of the imaging characteristic after the calibration is shown in Fig. 5. The image deviation in the X direction is excellently corrected at the both ends of the exposure angle of view, but the image distortion (DX) in the X direction cannot be corrected in the inner angle of view, resulting in creating a defective device in the job B.

A control method of an exposure process according to this embodiment to prevent such an influence will be described now. Fig. 6 is a flowchart illustrating the control method of an exposure process according to this embodiment.

When the job A is set, in step S101, the control unit 10 determines, based on the information of the job A or the apparatus status, whether it is necessary to update the currently set prediction coefficient K. For example, if a user desires an exposure process with higher accuracy than the default accuracy, an instruction to perform a highly accurate process can be included as the information of the job A. If such an instruction to perform a highly accurate process is included in the job A, in other words, if an instruction to update the prediction coefficient is set in the job A, the control unit 10 determines that it is necessary to update the prediction coefficient K. If it is not required to update the prediction coefficient K, in step S102, the control unit 10 exposes each wafer in accordance with the procedure shown in Fig. 10B. That is, in this case, normal exposure without actual measurement of the imaging characteristic is performed. On the other hand, if it is necessary to update the prediction coefficient K, in processing from step S103, the control unit 10 exposes each wafer in accordance with the procedure shown in Fig. 10A. That is, in this case, the process enters the actual measurement mode, and follows the sequence in which the imaging characteristic is measured immediately before exposing each wafer. In step S103, the control unit 10 determines whether the exposure angle of view set in the job A is smaller than a predetermined angle of view limit value. The angle of view limit value is a value for determining whether the imaging characteristic is also measured outside the exposure angle of view in the sequence shown in Fig. 10A. The smaller the angle of view limit value, the larger the high-order component of the image height of the imaging characteristic, so that measurement outside the exposure angle of view is required. If the exposure angle of view set in the job A is equal to or larger than the angle of view limit value, in step S104, the control unit 10 actually measures the imaging characteristic only inside the exposure angle of view before exposing each wafer. On the other hand, if the exposure angle of view set in the job A is smaller than the angle of view limit value, in step S105, the control unit 10 actually measures the imaging characteristic not only inside the exposure angle of view but also outside the angle of view before exposing each wafer in the job A.

As a specific example, assume that the exposure angle of view of the job A is an exposure angle of view corresponding to an exposure range of X = ±6.5 mm (that is, 13 mm), and the angle of view limit value is set to an angle of view corresponding to an exposure range of 20 mm. In this case, in step S103, the condition "the exposure angle of view < the angle of view limit value" is satisfied, so that the process advances to step S104, and the imaging characteristic is measured both inside and outside the exposure angle of view. In order to perform measurement at least outside the exposure angle of view, it is necessary to irradiate the measurement marks while changing an exposure angle of view for measurement to be larger than the exposure angle of view in the job A. For example, the exposure angle of view for measurement is expanded to the exposure angle of view corresponding to an exposure range of X = ±13 mm (that is, 26 mm) such that the inside and outside of the exposure angle of view can be collectively measured. Alternatively, a method may be employed in which the exposure angle of view for measurement is narrowed to a small exposure angle of view capable of irradiating only the measurement mark for one image height, and the exposure angle of view is moved in the X direction for each image height to be measured.

In step S106, the control unit 10 obtains the prediction coefficient K using the measured values (results of actual measurements) of the imaging characteristic obtained in step S104 or S105, and overwrites the job A with the new prediction coefficient K, thereby updating the prediction coefficient K.

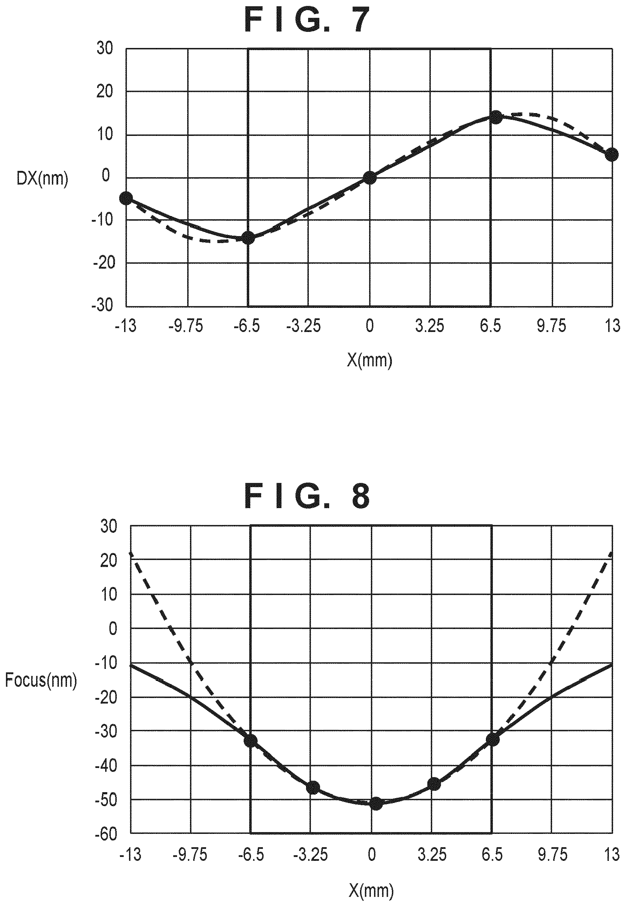

Fig. 7 shows an example of the image height fitting result obtained when the imaging characteristic is measured also outside the exposure angle of view in step S105. Filled circles respectively indicate the measured values at five image heights with X = 0 mm, ±6.5 mm, and ±13 mm. The result of X image height fitting on these measured values is indicated by a broken line, and the obtained order components are as follows:

$$\text{the first-order component (magnification) of the X image height: } 2.74$$

$$\text{nm/mm} \quad ...(8)$$

$$\text{the third-order component (distortion) of the X image height: } -0.0140$$

$$\text{nm/mm}^3 ...(9)$$

Since the high-order component of the image height is accurately obtained, the prediction coefficient K obtained using equations (3) to (5) can be correctly obtained. Therefore, even if the job B with a wide exposure angle of view set therein is input after the job A using the correctly obtained prediction coefficient K, a device failure in the job B as described above does not occur.

Note that in the example described above, measurement is performed at each of five image heights with X = 0 mm, ±6.5 mm, and ±13 mm, but in order to measure the third- or higher-order component of the image height, the number of the image heights to be measured is only required to be equal to or larger than five.

<Second Embodiment>

In the first embodiment described above, the example has been described in which image deviation (DX) is measured as the imaging characteristic. However, it is also possible to measure focus deviation as the imaging characteristic. Fig. 8 shows focus deviation immediately before exposing, for example, the fifth wafer. As in the case of the image deviation DX, the influence of heat is different between inside and outside the exposure angle of view, so that a high-order component of the image height of the focus deviation occurs. When measurement is performed at each of five image heights with X = 0 mm, ± 3.5 mm, and ± 6.5 mm inside the exposure angle of view, image height fitting as indicated by a broken line is performed, resulting in obtaining an incorrect prediction coefficient K.

In order to cope with it, in the second embodiment, when measuring the imaging characteristic (focus deviation), the coefficient is determined at the image heights including outside the exposure angle of view. This enables correct prediction of the imaging characteristic (focus deviation).

Here, focus deviation has been representatively described, but the same applies to an astigmatism, a spherical aberration, and a coma aberration.

<Other Embodiments>

In the first and second embodiments, the exposure angle of view of the job A corresponds to an exposure range of X = -6.5 mm to +6.5 mm, so that it is symmetric with respect to the optical axis. However, the exposure range need not be symmetric with respect to the optical axis. For example, as in a case in which the exposure angle of view is set to be an exposure angle of view corresponding to an exposure range of X = 0 mm to +13 mm, even if the exposure range is asymmetric with respect to the optical axis, a correct prediction coefficient K can be obtained by measuring the imaging characteristic at each of the measurement image heights inside and outside the exposure angle of view and fitting the results to the image height up to high-order component.

In the first and second embodiments described above, when measuring the imaging characteristic, the measurement marks 8 provided on the exposure apparatus are measured by the sensor, but measurement marks arranged on a mask 2 may be used for measurement. An example of the mask with the measurement marks arranged thereon is shown in Fig. 9. Measurement may be performed using a sensor mounted in the exposure apparatus, or the imaging characteristic may be obtained by exposing a waver for measurement and measuring the positional deviation or focus deviation of the marks after the exposure.

<Embodiment of Article Manufacturing Method>

An article manufacturing method according to an embodiment of the present invention suitably manufactures an article, for example, a microdevice such as a semiconductor device or an element having a microstructure. The article manufacturing method of this embodiment includes a step of forming a latent pattern by using the above-described exposure apparatus on a photosensitive agent applied on a substrate (a step of exposing the substrate), and a step of developing the substrate on which the latent pattern has been formed in the above step. In addition, the manufacturing method includes other well-known steps (oxidation, film formation, deposition, doping, planarization, etching, resist removal, dicing, bonding, packaging, and the like). The article manufacturing method of this embodiment is more advantageous than the conventional methods in at least one of the performance, quality, productivity, and production cost of the article.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

An exposure apparatus that exposes a substrate is provided. The apparatus comprises a projection optical system (4) configured to project a pattern of a mask (2) onto the substrate, an adjusting unit (7a) configured to adjust an imaging characteristic of the projection optical system, and a control unit (10) configured to predict, using a prediction formula, a fluctuation of the imaging characteristic caused by the projection optical system absorbing exposure energy, control the adjusting unit based on a result of the prediction, and expose the substrate. The controller applies a mode in which, in a job for sequentially exposing a plurality of substrates, the imaging characteristic is measured before exposing each substrate, and after the job is completed, a prediction coefficient in the prediction formula is updated based on respective measurement results. In the mode, the imaging characteristic is measured not only inside an exposure angle of view set in the job but also outside the exposure angle of view set in the job.

**Claims**

1. An exposure apparatus that exposes a substrate (5), **characterized by** comprising:

   a projection optical system (4) configured to project a pattern of a mask (2) onto the substrate;
   an adjusting unit (7a) configured to adjust an imaging characteristic of the projection optical system; and
   a control unit (10) configured to predict, using a prediction formula, a fluctuation of the imaging characteristic caused by the projection optical system absorbing exposure energy, control the adjusting unit based on a result of the prediction, and expose the substrate,
   wherein the control unit applies a mode in which, in a job for sequentially exposing a plurality of substrates, the imaging characteristic is measured before exposing each substrate, and after the job is completed, a prediction coefficient in the prediction formula is updated based on respective measurement results, and
   in the mode, the imaging characteristic is measured not only inside an exposure angle of view set in the job but also outside the exposure angle of view set in the job.

2. The apparatus according to claim 1, **characterized by** further comprising:

   a mask stage (3) configured to hold the mask and including a plurality of measurement marks (8 in Fig. 11) arranged over a length corresponding to a maximum exposure angle of view;
   a substrate stage (6) configured to hold the substrate; and
   a measurement device (15) provided in the substrate stage and configured to detect light transmitted through the plurality of measurement marks and the projection optical system,
   wherein the control unit measures the imaging characteristic up to the maximum exposure angle of view using the measurement device.

3. The apparatus according to claim 1, **characterized in that**
   the mask includes a plurality of measurement marks (8 in Fig. 9) arranged over a length corresponding to a maximum exposure angle of view,
   the apparatus comprises:

   a substrate stage (6) configured to hold the substrate; and
   a measurement device (15) provided in the substrate stage and configured to detect light transmitted through the plurality of measurement marks and the projection optical system, and
   the control unit measures the imaging characteristic up to the maximum exposure angle of view using the measurement device.

4. The apparatus according to any one of claims 1 to 3, **characterized in that** when an instruction to update the prediction coefficient is set in the job, the control unit applies the mode.

5. The apparatus according to any one of claims 1 to 4, **characterized in that** in the mode, the control unit measures the imaging characteristic inside the exposure angle of view if the exposure angle of view set in the job is not smaller than a predetermined angle of view limit value, or measures the imaging characteristic not only inside the exposure angle of view but also outside the exposure angle of view if the exposure angle of view is smaller than the angle of view limit value.

6. The apparatus according to any one of claims 1 to 5, **characterized in that** the control unit obtains the prediction coefficient by fitting the prediction formula to time-series data of the imaging characteristic obtained as the respective measurement results.

7. The apparatus according to any one of claims 1 to 6, **characterized in that** the imaging characteristic includes at least one of a focus, a magnification, a curvature of field, a distortion, an astigmatism, a spherical aberration, and a coma aberration.

8. The apparatus according to claim 1, **characterized by** further comprising:

   a mask stage (3) configured to hold the mask; and
   a substrate stage (6) configured to hold the substrate,
   wherein the adjusting unit adjusts the imaging characteristic by performing at least one of driving of an optical element of the projection optical system, driving of the mask stage, and driving of the substrate stage.

9. An article manufacturing method **characterized by** comprising:

exposing a substrate using an exposure apparatus defined in any one of claims 1 to 8, and
developing the exposed substrate,
wherein an article is manufactured from the developed substrate.

# F I G. 1

# F I G. 2

# F I G. 3

# F I G. 4

# FIG. 5

# FIG. 6

SET IN JOB A

S101
IS IT NECESSARY TO UPDATE PREDICTION COEFFICIENT K?

NO → S102
NORMAL EXPOSURE

YES

S103
EXPOSURE ANGLE OF VIEW < ANGLE OF VIEW LIMIT VALUE?

NO → S104
ACTUALLY MEASURE IMAGING CHARACTERISTIC ONLY INSIDE EXPOSURE ANGLE OF VIEW IN JOB A

YES → S105
ACTUALLY MEASURE IMAGING CHARACTERISTIC INSIDE EXPOSURE ANGLE OF VIEW AND OUTSIDE ANGLE OF VIEW IN JOB A

UPDATE PREDICTION COEFFICIENT K USING RESULTS OF ACTUAL MEASUREMENTS AFTER JOB A COMPLETED — S106

# F I G. 7

# F I G. 8

# F I G. 9

# F I G. 10A

IMAGING CHARACTERISTIC ACTUAL MEASUREMENT

| LOAD WAFER 1 | Calib. | | EXPOSE WAFER 1 | UNLOAD WAFER 1 | LOAD WAFER 2 | | EXPOSE WAFER 2 | ··· |

MEASURE IMAGING
CHARACTERISTIC

# F I G. 10B

NORMAL EXPOSURE

| LOAD WAFER 1 | Calib. | EXPOSE WAFER 1 | UNLOAD WAFER 1 | LOAD WAFER 2 | EXPOSE WAFER 2 | ··· |

# F I G. 11

Europäisches
Patentamt
European
Patent Office
Office européen
des brevets

# EUROPEAN SEARCH REPORT

Application Number

EP 20 17 4894

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2019/086822 A1 (ARAHARA KOSHIRO [JP]) 21 March 2019 (2019-03-21) * paragraphs [0024] - [0036], [0051] - [0061], [0144]; figures 1A, 6 * ----- | 1-9 | INV. G03F7/20 G03F9/00 |
| Y | US 2006/114437 A1 (AKHSSAY M HAMED [NL] ET AL) 1 June 2006 (2006-06-01) * paragraphs [0029], [0034]; claim 15 * ----- | 1-9 | |

TECHNICAL FIELDS
SEARCHED       (IPC)

G03F

The present search report has been drawn up for all claims

| Place of search | Date of completion of the search | Examiner |
|---|---|---|
| Munich | 21 October 2020 | Eisner, Klaus |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 20 17 4894

This annex lists the patent family members relating to the patent documents cited in the above-mentioned European search report.
The members are as contained in the European Patent Office EDP file on
The European Patent Office is in no way liable for these particulars which are merely given for the purpose of information.

21-10-2020

| Patent document cited in search report | | Publication date | Patent family member(s) | | Publication date |
|---|---|---|---|---|---|
| US 2019086822 | A1 | 21-03-2019 | CN 109541891 A<br>JP 2019056830 A<br>KR 20190033452 A<br>TW 201925920 A<br>US 2019086822 A1 | | 29-03-2019<br>11-04-2019<br>29-03-2019<br>01-07-2019<br>21-03-2019 |
| US 2006114437 | A1 | 01-06-2006 | JP 2006157020 A<br>US 2006114437 A1 | | 15-06-2006<br>01-06-2006 |

EPO FORM P0459

For more details about this annex : see Official Journal of the European Patent Office, No. 12/82

**EP 3 745 206 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 6381188 B

- JP 7012012 A